# EUROPÄISCHE PATENTANMELDUNG

(11) **EP 1 876 454 A1**
(43) Veröffentlichungstag der Anmeldung: **09.01.2008**
(21) Anmeldenummer: 07111644.6
(22) Anmeldetag: 03.07.2007
(51) Int. Cl.: G01R 1/04, G01R 31/28

(54) **Verfahren zum elektrischen Testen von Chips**

(30) Priorität: 07.07.2006 DE 102006031568
(71) Anmelder: SIEMENS AKTIENGESELLSCHAFT, 80333 München (DE)
(72) Erfinder: Gerhard, Detlef, 81829, München (DE); Heim, Ralf, 85375, Neufahrn (DE); Lechner, Johannes, 80798, München (DE)

(57) **Zusammenfassung**

Verfahren zum elektrischen Testen von auf einer Folie (4) mit Rahmen (3) befindlichen Chips (2), wobei
die Chips (2) mit ihrer der Folie (4) gegenüberliegenden Seite auf einem Chuck (6) aufgelegt werden und dort einseitig kontaktiert werden,
ein Chip durch mindestens eine relativ zu diesem bewegte die Folie (4) durchdringende Messnadel (1) kontaktiert wird,
ein elektrischer Messvorgang durchgeführt wird.

## Beschreibung

Die Erfindung betrifft ein Verfahren zur elektrischen Prüfung von elektronischen Bauelementen, die während der Fertigung auf eine Folie aufgebracht sind. Diese Folien sind in der Regel auf einem mechanischen stabilen Ring, dem so genannten Rahmen oder frame befestigt. Die Wafer oder auch die vereinzelten Chips kleben an der Folie.

Wafer werden nach deren Prozessierung einem elektrischen Test unterzogen. Während des Tests werden die auf dem Wafer befindlichen Chips elektrisch kontaktiert und gemessen. Hierzu werden die Wafer, die zu diesem Zeitpunkt noch nicht vereinzelt sind, manuell oder automatisch auf dem Chuck des Mess-Systems (Träger) so aufgelegt, dass die Chips und auch die Kontakte der Chips nach oben zeigen. Der Chuck selbst ist elektrisch leitend, so dass Mess-Ströme über den Chuck abfließen können. Zum Kontaktieren wird innerhalb des Mess-Systems üblicherweise eine auf den Chiptyp abgestimmte Messnadelkarte verwendet. Die Kontaktierung erfolgt durch Anheben des Chucks, wodurch die elektrischen Kontaktpunkte des Chips, die so genannten Pads, an die Messnadeln gedrückt werden. Nach der Kontaktierung beginnt der Messprozess. Nach Abschluss des Messprozesses senkt sich der Chuck und der nächste Chip oder die nächsten Chips werden den Messnadeln der Messkarte zugeführt und kontaktiert.

Manche Wafer lassen sich auf diese Weise nicht elektrisch testen. Für derartige Wafer müssen die zu messenden Chips zuvor vereinzelt werden, was bedeutet, dass der Wafer zunächst zerlegt werden muss. Zur Vereinzelung der Chips wird der Wafer auf einen Rahmen (frame), der aus einem Kunststoff- oder Metallrahmen und einer Sägefolie mit Klebeschicht besteht, aufgeklebt. Der Wafer liegt dabei oben auf. Der Rahmen mit dem Wafer wird dem Sägeprozess zugeführt. Dabei trennt eine Säge in der Regel durch gerade Sägespuren den Wafer in die einzelnen Chips, wobei die Sägespuren selbstverständlich an den Chipgrenzen positioniert sind. Nach dem Sägeprozess sind die Chips vereinzelt und kleben auf der Sägefolie des Rahmens.

Zum elektrischen Testen vereinzelter Chips müssen einerseits die Messnadel bzw. mehrere Messnadeln trotz undefinierter Chiplage die Messpunkte an den Chips treffen. Dabei ist es nachteilig, dass die die Chips tragende Kunststoff-Folie elektrisch nicht leitend ist. Somit kann der Chip insgesamt nur von oben mit Messnadeln elektrisch kontaktiert werden.

Für das Vermessen einzelner Chips gibt es im Stand der Technik zwei Möglichkeiten:
a) Der Chip wird ungemessen weiter verarbeitet, was bedeutet, dass er eingehäust und anschließend dem Bauelementetest zugeführt wird.
b) Der Chip wird einzeln vom Rahmen abgenommen (gepickt), gemessen und anschließend sortiert auf einem zweiten Rahmen abgelegt.

Beide Verfahren besitzen wesentliche Nachteile.
Die Verfahrensweise a) beinhaltet, dass der Chip erst nach dem Vergießen bzw. Einhausen vermessen werden kann und somit elektrisch fehlerhafte Chips bis zu diesem Prozess-Schritt ganz normal weiter behandelt werden, obwohl die Chips teilweise nicht funktionsfähig sind und somit keine positive Ausbeute ergeben. Fehler werden in diesem Fall grundsätzlich erst zu spät erkannt werden.
Die Verfahrensweise b) beinhaltet, dass diese Chips vom Rahmen bzw. von der Folie abgelöst werden müssen, wodurch zusätzlicher beträchtlicher Fertigungsaufwand entsteht. Die Chips können durch das Abzupfen beschädigt werden. Beispielsweise ist der Verfahrensablauf nach dem Ablösen von der Folie mit einer Messung verbunden, mit anschließendem Ablegen des Chips, was in einem zeitlichen Rahmen von 1 bis 2 Sekunden passiert. Gegenüber einer normalen elektrischen Messprozedur, die ca. 100 bis 200 ms benötigt, ist diese Prozesszeit um den

Faktor 10 höher. Darüber hinaus ist ein aufwändiger Maschinenpark vorzuhalten, wenn auf diese Weise alle Chips gemessen werden.

Ein Anliegen der Erfindung ist somit, für ein Verfahren zu sorgen, mittels dem vereinzelte Chips auf einer Folie elektrisch getestet werden können, obwohl die Chips nur einseitig elektrisch zugänglich sind. Die Lösung dieser Aufgabe geschieht durch die Kombination der Merkmale, wie sie im Patentanspruch 1 enthalten sind.

Vorteilhafte Ausgestaltungen können den Unteransprüchen entnommen werden.

Die Erfindung beruht auf der Verfahrensweise, dass der Rahmen mit Folie mit darauf bereits vereinzelten Chips so auf einem Chuck aufliegt, dass die Chips die Chuckfläche berühren und die Folie, auf der die Chips haften, auf der anderen Seite der Chips positioniert ist. Damit liegen die Chips mit ihrer freien Seite auf dem elektrisch leitenden Chuck auf und sind oben mit der Folie abgedeckt.

Einzelne Chips können nun durch eine relativ zum Chip bewegte Messnadel kontaktiert werden, wobei diese Messnadel die Folie, an der der Chip haftet, durchdringt.

Es ist vorteilhaft, auch mehrere Messnadeln in Richtung auf einen Chip zu bewegen, so dass mehrere Stellen auf der Chipoberfläche zur Messung kontaktiert werden können.

Es ist besonders vorteilhaft, für die Relativbewegung zwischen Messnadel und Chip einen piezoelektrischen Antrieb einzusetzen.

Zur Lageerkennung der Chips auf dem Rahmen wird ein Kamerasystem als Sensor verwendet. Insbesondere wird eine Bildaufnahme betrieben, die eine Zeilenkamera am bewegten Chuck vorsieht. Somit wird der Rahmen durch mindestens einen Bildstreifen abgebildet.

Es ist sehr vorteilhaft, zum Durchstoßen der Folie Messnadeln mit erhöhter Temperatur zu verwenden, was durch eine Beheizung der Messnadeln gesichert wird. Dabei kann die Messnadeltemperatur unterschiedlich eingestellt werden.

Im Folgenden wird anhand von zwei schematischen Figuren ein Ausführungsbeispiel beschrieben, wobei im einzelnen folgendes gezeigt wird:
Figur 1 zeigt die Darstellung von Rahmen/frame und Chipkontaktierung in der Seitenansicht, in Schnittdarstellung,
Figur 2 zeigt eine Anordnung entsprechend Figur 1 in der Aufsicht.

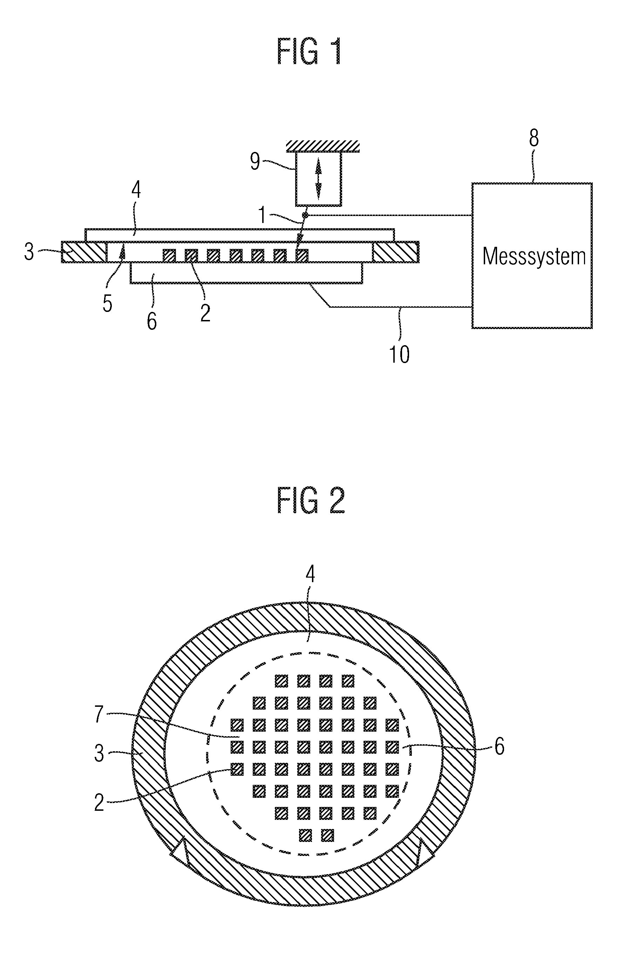

Das hauptsächliche Thema der Erfindung besteht in der möglichen Kontaktierung von vereinzelten Chips, die sich noch aufgeklebt auf einer Folie befinden. Dies kann entsprechend der Merkmalskombination des Anspruchs 1 bewältigt werden, wobei der Rahmen mit vereinzelten Chips auf einem Chuck aufliegt. Entsprechend Figur 1 wird dargestellt, dass der Aufbau von Folie 4, Klebstoffschicht 5 und Chip 2 auf dem Kopf stehend, d.h. ihn in dieser Reihenfolge von oben nach unten auf einem Chuck 6 aufliegt. Der Rahmen/Frame 3 ist wie üblich zur Spannung bzw. zur Stabilisierung der Folie 4 vorgesehen. Damit berühren die Chips mit einer Seite die Chuckoberfläche und auf ihrer gegenüberliegenden Seite ist die Folie über die Klebstoffschicht 5 aufgebracht. Die Chips werden durch eine relativ zum Chip bewegte Messnadel kontaktiert. Die Messnadel durchsticht dabei die Folie auf der der Chip haftet. Es können auch mehrere Messnadeln für die Kontaktierung eines Chips vorgesehen werden, die dann vorzugsweise gleichzeitig und gleichmäßig abgesenkt bzw. relativ zu dem Chip bewegt werden. Damit können mehrere Stellen an der Chipoberfläche zur Messung kontaktiert werden. Für eine Relativbewegung zwischen Messnadel und Chip wird vorzugsweise ein piezoelektrischer Antrieb verwendet. Zur Lageerkennung der Chips 2 auf dem Rahmen 3 wird vorzugsweise ein Kamerasystem als Sensor verwendet. Dies ist in den Figuren 1 und 2 nicht dargestellt. Die Bildaufnahme wird mit einer Zeilenkamera am bewegten Chuck 6 durchgeführt. Der Rahmen 3 wird durch mindestens einen Bildstreifen abgebildet. Ein Bildstreifen besteht aus mehreren Bildzeilen, wobei je eine Bildzeile einer Kamerazeile der Zeilenkammer zugeordnet werden kann.

Vorzugsweise wird die Bildaufnahme mit einer zweidimensionalen Kamera durchgeführt, wobei die Kamera die Chips durch die Folie hindurch abbildet.

Die Ausbildung von Klebstoffschichten 5 kann unterschiedlich geschehen. Vorzugsweise wird ein Rahmen mit einer UVempfindlichen Klebefolie verwendet. Ein solcher Rahmen mit entsprechender Folie und darauf haftenden Chips wird von der Chipseite her belichtet, so dass kein Licht unterhalb der von Chips bedeckten Fläche einfällt. Die belichteten Klebestellen verlieren durch das Belichten einen großen Teil der Haftkraft.

Zum Durchstechen bzw. Durchstoßen der Folien mit der Messnadel oder den Messnadeln werden die Messnadeln vorzugsweise beheizt. Die Messnadeltemperatur kann dabei einstellbar sein.

Es wird über den elektrischen Kreis, bestehend aus Messnadel, Chip, Mess-System ein elektrischer Wert gemessen. Mit Hilfe eines entsprechend einstellbaren Sollwertes wird entschieden, wann die Relativbewegung bzw. die Bewegung, in der Nadeln und Chip aufeinander zufahren, beendet wird. Im Anschluss an den Stillstand dieser Relativbewegung werden die Messkontakte elektrisch umgeschaltet, so dass eine Messung am Chip ablaufen kann.

In Figur 1 ist neben Messnadel 1, Chip 2, Rahmen 3, Folie 4, Klebstoffschicht 5 und Chuck 6 auch ein Mess-System 8 angedeutet. Dieses kontaktiert elektrisch einerseits den Chuck 6 und andererseits eine oder mehrere Messnadeln 1. Die Relativbewegung kann über einen piezoelektrischen Antrieb 9 ausgeführt werden. In Figur 1 ist die elektrische Kontaktierung zwischen Mess-System 8 und Chuck 6 mit der Bezugsziffer 10 gekennzeichnet.

Figur 2 zeigt in der Auf- oder auch Unteransicht einen Rahmen 3 mit Folie 4, wobei die Umrisse des Chucks 6 angedeutet sind. Weiterhin ist ein rechtwinkeliges geradliniges Muster von Sägespuren 7 erkennbar. Dies ist durch eine entsprechende Sägeeinrichtung zum Zerteilen eines Wafers in die dargestellten Chips 2 ausgeführt worden.

## Patentansprüche

1. Verfahren zum elektrischen Testen von auf einer Folie (4) befindlichen Chips (2), wobei
- die Chips (2) mit ihrer der Folie (4) gegenüberliegenden Seite auf einem Chuck (6) aufgelegt werden und dort einseitig kontaktiert werden,
- ein oder mehrere Chips durch mindestens eine relativ zu diesem bewegte die Folie (4) durchdringende Messnadel (1) kontaktiert wird/werden, und
- ein elektrischer Messvorgang durchgeführt wird.

2. Verfahren nach Anspruch 1, bei dem mittels einer Anordnung von Messnadeln (1) kontaktiert wird.

3. Verfahren nach einem der vorhergehenden Ansprüche, bei dem Messnadeln (1) beheizt werden.

4. Verfahren nach einem der vorhergehenden Ansprüche, bei dem zur Lageerkennung der Chips (2) ein Kamerasystem eingesetzt wird,

5. Verfahren nach einem der vorhergehenden Ansprüche, bei dem die relative Bewegung zur Kontaktierung zwischen mindestens einer Messnadel (1) und einem Chip (2) beim Erreichen eines Sollwertes im elektrischen Mess-System (8) beendet wird und ein Messmodus beginnt.

6. Verfahren nach einem der vorhergehenden Ansprüche, bei dem zur Darstellung einer Relativbewegung zwischen Messnadeln (1) und Chips (2) ein piezoelektrischer Antrieb (9) eingesetzt wird.
